# EUROPEAN PATENT APPLICATION

(11) **EP 4 391 751 A1**
(43) Date of publication of application: **26.06.2024**
(21) Application number: 22383240.3
(22) Date of filing: 19.12.2022
(51) Int. Cl.: H05K 7/20

(54) **MODULAR CONTAINERIZED UPS**

(71) Applicant: Schneider Electric IT Corporation, Foxboro, MA 02035 (US)
(72) Inventor: BADOSA VIRALTA, Xavier, 08830 SANT BOI DE LLOBREGAT (ES)
(74) Representative: Plasseraud IP

(57) **Abstract**

A UPS system includes a UPS module having a first housing and a first sensor outputting first data, a battery module having a second housing and a second sensor outputting second data, and a central controller that is external to the first housing of the UPS module and the second housing of the battery module. The central controller is coupled to the UPS module and the battery module and is configured to receive the first data and the second data. The UPS system further includes at least one cooling module contained within a frame structure. The at least one cooling module is configured to provide cooling to the UPS module. The frame structure includes a first vent configured to exhaust warm air.

## Description

### BACKGROUND OF DISCLOSURE

### Field of Disclosure

Aspects of the present disclosure relate generally to data centers, including microdata centers, small rooms and closets, that contain racks and enclosures used to house data processing, power, networking and telecommunications equipment.

### Discussion of Related Art

Equipment enclosures or racks for housing electronic equipment, such as data processing, power, networking and telecommunications equipment have been used for many years. Such racks are used to contain and to arrange the equipment in small wiring closets, microdata centers, small rooms, as well as equipment rooms and large data centers. An equipment rack can be an open configuration and can be housed within a rack enclosure, although the enclosure may be included when referring to a rack.

A data center can be configured with hundreds of equipment racks that support various types of computer-related equipment. When equipment racks are installed within a data center, a physical layout of the equipment racks, configuration and wiring of electrical power connections to the equipment racks, a physical layout of cooling equipment, and a layout of connectivity wiring and networking systems must be performed. Typically, these procedures are completed onsite at the data center site by tradesmen. Such installation can be customized to consider local constraints.

In lieu or in addition to such data centers, a modular or mobile data center may be provided. A modular data center is a portable solution to deploy data center capacity. A modular data center can be placed anywhere data capacity is needed. In some embodiments, a modular data center includes a modular container, e.g., an ISO (International Organization for Standardization) container having pre-engineered electronic modules and components to offer scalable data center capacity with multiple power and cooling options. A data center module is configured to be shipped to a desired location and integrated or retrofitted into an existing data center or combined into a system of modules. Modular data centers typically consist of standardized components.

Modular data centers often include several separate subsystems that are associated with an uninterruptible power supply ("UPS"), e.g., a UPS module, battery, and a cooling system, each having separate controllers with separate control processing units ("CPUs"). This is undesirable for several reasons. One reason is that different firmware upgrades must be performed for each controller. Another reason is that performance of the system is difficult to optimize because there are multiple sets of firmware for each controller. Yet another reason is that room must be provided to store and access different controllers. Another reason, in today's difficult supply chain climate, CPUs are limited in supply and oftentimes difficult to obtain.

### SUMMARY OF DISCLOSURE

One aspect of the present disclosure is directed to a UPS system comprising a UPS module including a first housing and a first sensor outputting first data, a battery module including a second housing and a second sensor outputting second data, and a central controller that is external to the first housing of the UPS module and the second housing of the battery module. The central controller is coupled to the UPS module and the battery module and is configured to receive the first data and the second data.

Embodiments of the UPS system further may include a cooling module including a third housing and being configured to provide cooling to the UPS module. The first sensor may be configured to measure temperature within the first housing and the first data relates to temperature data of the first housing. The central controller may be configured to control the operation of the cooling module based on the first data and the second data. The cooling module may include a heat exchanger and a fan configured to move air over the heat exchanger. The UPS system further may include a frame structure configured to contain the UPS module and the battery module. The central controller may be coupled to the frame structure. The frame structure may include a vent to exhaust warm air. The second sensor may be configured to measure a state of charge of the battery module and the second data relates to the state of charge. The second sensor may be configured to measure temperature within the second housing and the second data relates to temperature data of the second housing. The UPS system further may include a frame structure configured to contain the UPS module and the battery module. The central controller may be coupled to the frame structure. The frame structure may include a first vent configured to direct cool air to flow over the battery module and a second vent configured to exhaust warm air from the battery module. The battery module may include a dedicated cooling module coupled to the central controller and configured to direct cool air to the battery module. The UPS system further may include a power block including the central controller. The UPS system further may include a frame structure. The power block may be coupled to the frame structure. The frame structure may include a first vent configured to direct cool air to the power block and a second vent configured to exhaust warm air from the power block. The UPS system further may include a user interface coupled to the central controller. The user interface may be configured to enable a user to control the operation of at least one of the UPS module or the battery module. The UPS system further may include at least one additional UPS module coupled to the central controller. The UPS module may be rated for at least about 1 MW. The UPS system further may include at least one additional battery module coupled to the central controller. The UPS system further may include a frame structure configured to contain the UPS module and the battery module. The central controller may be coupled to the frame structure. The frame structure may be an ISO container.

Another aspect of the present disclosure is directed to a UPS system comprising a frame structure, at least one UPS module contained within the frame structure, at least one battery module contained within the frame structure, at least one cooling module contained within the frame structure, and a central controller coupled to the frame structure. The central controller is coupled to the at least one UPS module and the at least one battery module. The at least one cooling module is configured to provide cooling to a UPS module of the at least one UPS module. The frame structure includes a first vent configured to exhaust warm air.

Embodiments of the UPS system further may include configuring the frame structure to have a first vent configured to direct cool air to flow over the battery module and a second vent configured to exhaust warm air from the battery module. The battery module may include a dedicated cooling module configured to direct cool air to the battery module. The at least one cooling module may include up to four cooling modules, each cooling module of the up to four cooling modules being supported by the frame structure and coupled to the central controller. Each cooling module of the up to four cooling modules may include a heat exchanger and a fan configured to move air over the heat exchanger. The UPS system further may include a power block supported by the frame structure, the power block including the central controller. The frame structure may include a first vent configured to direct cool air to the power block and a second vent configured to exhaust warm air from the power block. The UPS system further may include a user interface coupled to the central controller. The user interface may be configured to enable a user to control the operation of the UPS module and the battery module. The at least one UPS module may include up to four UPS modules. Each UPS module of the up to four UPS modules may be supported by the frame structure and coupled to the central controller. Each UPS module of the up to four UPS modules may include a 1 MW UPS. The at least one battery module may include up to four battery modules. Each battery module of the up to four battery modules may be supported by the frame structure and coupled to the central controller. The frame structure may be an ISO container.

### BRIEF DESCRIPTION OF DRAWINGS

Various aspects of at least one example are discussed below with reference to the accompanying figures, which are not intended to be drawn to scale. The figures are included to provide illustration and a further understanding of the various aspects and examples, and are incorporated in and constitute a part of this specification, but are not intended as a definition of the limits of the disclosure. In the figures, identical or nearly identical components illustrated in various figures may be represented by like numerals. For purposes of clarity, not every component may be labeled in every figure. In the drawings:
FIG. 1 is a perspective view of a modular containerized UPS system of the present disclosure;
FIG. 2 is a top view of the modular containerized UPS system;
FIG. 3 is a front view of the modular containerized UPS system;
FIG. 4 is a top view of the modular containerized UPS system showing an electrical schematic of the system;
FIG. 5 is an electrical schematic of motorized breakers of the modular containerized UPS system;
FIG. 6 is a front view of the modular containerized UPS system showing airflow within the system;
FIG. 7 is a top view of the modular containerized UPS system showing airflow within the system;
FIG. 8 is a cross-sectional view taken along line 8--8 in FIG. 7; and
FIG. 9 is a cross-sectional view taken along line 9--9 in FIG. 7.

### DETAILED DESCRIPTION

A typical modular data center includes many if not most of the components found in a more traditional facility data center. In one certain example, the modular data center includes a 20-foot (6.1m), 40-foot (12.2m) or 45-foot (13.7m) ISO container, sometimes referred to herein as a "container," containing electrical equipment. One such system is a UPS system to provide dedicated power to a load. In one embodiment, the UPS system includes several UPS modules and several battery modules, which as mentioned above each include its own dedicated controller. The modular data center further includes a cooling system, embodying a cooling system associated with the container and one or more in-row cooling racks. Other equipment can be provided depending on the intended use of the modular data center. For example, additional cooling modules can be mounted within the ISO container or provided external to the ISO container.

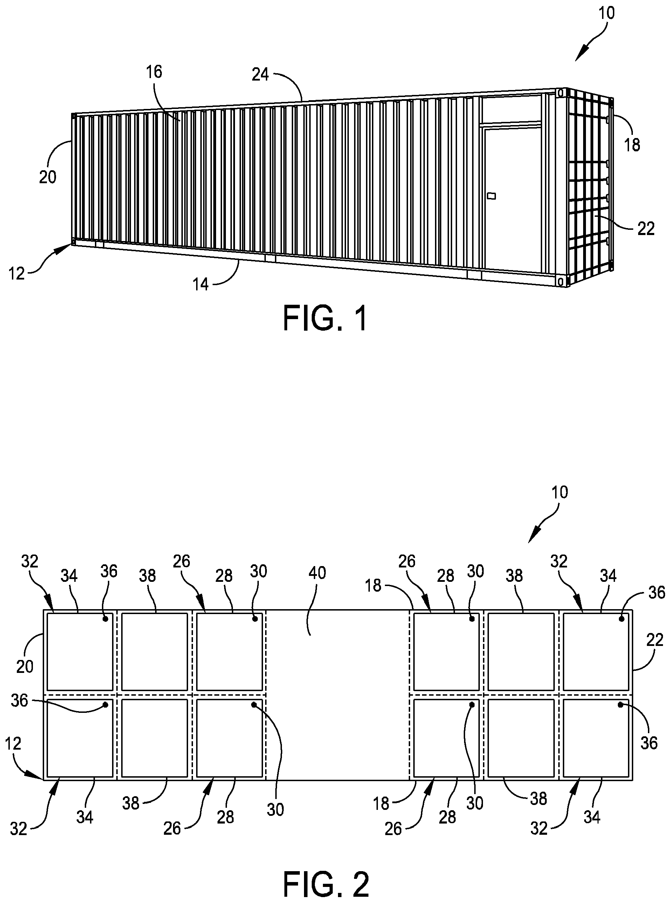

Referring to the drawings, and more particularly to FIG. 1, a modular containerized UPS system is generally indicated at 10. As shown, the UPS system 10 includes an ISO container, generally indicated at 12, which can embody a standard 20-foot, 40-foot or 45-foot container. The ISO container 12, sometimes referred to as an intermodal container or simply as a container, is a large, standardized shipping container that is configured for intermodal freight transport. Such containers are used in ship, rail, truck transport, without having to unload and reload its contents. ISO containers are used to store and transport materials and products in an efficient and cost-effective manner. Such ISO containers can be used for other purposes as well. For example, as described herein, an ISO container can be used as a mobile data center.

Modular data centers typically come in two types of form factors. One more common type, sometimes referred to as containerized data center or portable modular data centers, supports data center equipment including but not limited to servers, storage and networking equipment, into a standard, ISO shipping container, such as ISO container 12, which is then transported to a desired location. Containerized data centers typically come outfitted with their own control and cooling systems. Another type of modular data center supports data center equipment into a facility composed of prefabricated components that can be quickly built on a site and added to as capacity is needed. With the former type of data center, as mentioned above, the containerized data center is provided in a standard 20-foot, 40-foot or 45-foot ISO container.

As shown in FIG. 1, the ISO container 12 includes a floor 14, two side walls 16, 18, two end walls 20, 22, and a roof 24. The near side wall 16 defines a front of the ISO container 12 and a far side wall 18 defines a back of the ISO container as described herein. Doors can be provided in the traditional manner to access an interior of the ISO container 12. For example, in one embodiment, one end 20 or 22 may include double doors that are provided to access the interior of the ISO container 12. In another embodiment, one or more doors may be provided in the side walls 16, 18 of the ISO container 12.

Referring to FIG. 2, in the shown embodiment, the UPS system 10 includes several modules including four (4) UPS modules, each generally indicated at 26, positioned within the ISO container 12. Each UPS module 26 includes a first housing 28 configured to support the components of a UPS. The UPS module 26 is configured to provide emergency power to a load when a power source or mains power fails. The UPS module 26 provides continuous power to the load in the event of such a failure. While the UPS modules 26 provide short-term power to the load, the UPS modules also address voltage spikes, reduced input voltage, voltage sag, and frequency power issues. The first housing 28 of the UPS module 26 can include one or more sensors to measure parameters of the UPS module. For example, the first housing 28 of the UPS module 26 includes a first sensor 30 to output first data. In one embodiment, each UPS module 26 includes a 1 megawatt ("MW") UPS. However, the UPS module 26 can include a selected power capacity based on the size of the UPS module.

The UPS system 10 further includes several additional modules including four (4) battery modules, each generally indicated at 32, positioned within the ISO container 12. In the shown embodiment, there is a battery module 32 for each UPS module 26. The battery modules 32 provide backup battery power to the UPS system 10. Each battery module 32 includes a second housing 34 configured to support components of the battery module. The battery module 32 provides backup power to the load and operates with the UPS module 26 to provide seamless power to the load. The second housing 34 of the battery module 32 can include one or more sensors to measure parameters of the battery module. For example, the second housing 34 of the battery module 32 includes a second sensor 36 to output second data.

The UPS system 10 further includes several cooling modules including four (4) cooling modules, each indicated at 38, positioned within the ISO container 12. In the shown embodiment, there is a cooling module 38 for each UPS module 26. The cooling modules 38 provide dedicated cooling to the UPS module 26. In one embodiment, the cooling module 38 is positioned between the UPS module 26 and the battery module 32. The UPS system 10 further can include other types of cooling. For example, the ISO container 12 can include a cooling system that is external or internal to the ISO container to provide environmental temperature control within an interior of the ISO container.

It should be understood that the provision of four (4) UPS modules 26, four (4) battery modules 32, and four (4) cooling modules 38 within the ISO container 12 can be modified depending on the size of the ISO container and the level of capacity required. For example, the ISO container 12 can be configured with one (1) UPS module 26, one (1) battery module 32, and one (1) cooling module 38 in one configuration, or be configured with two (2) UPS modules, two (2) battery modules, and two (2) cooling modules in another configuration, or be configured with three (3) UPS modules, three (3) battery modules, and three (3) cooling modules in yet another configuration. Any number of configurations can be provided depending on many factors, including the size of the load.

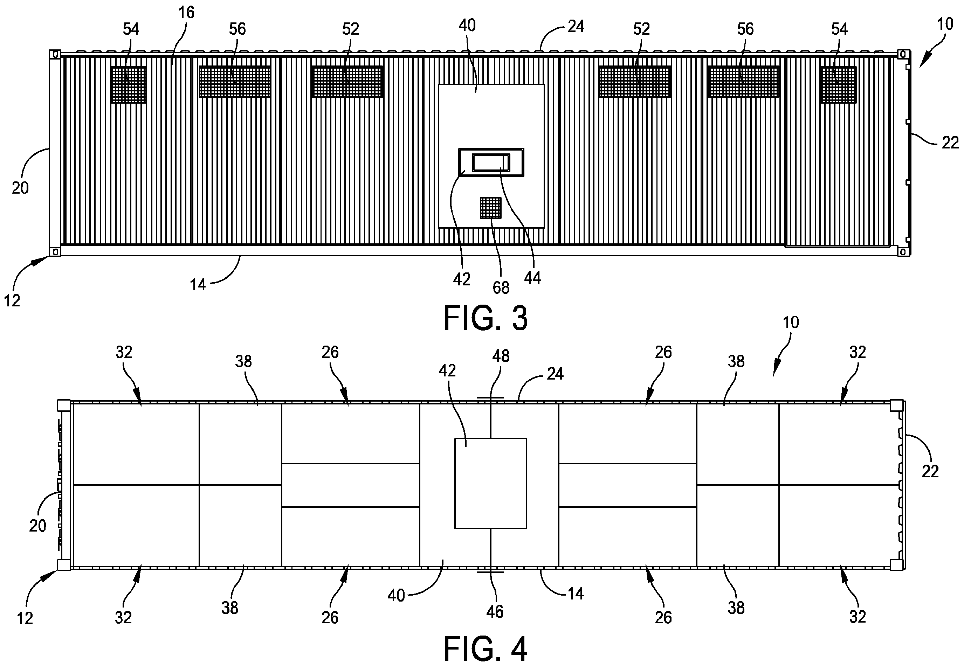

Referring additionally to FIG. 3, the UPS system 10 further includes a power block 40 coupled to the ISO container 12 to provide centralized control of the modules 26, 32, 38 contained within the ISO container. In one embodiment, the power block 40 is positioned on the near side wall 16 of the ISO container 12. The power block 40 includes a central controller 42 that is coupled to the UPS modules 26, the battery modules 32 and the cooling modules 38 to provide centralized control of these modules. Thus, unlike prior systems, a single controller can be used to control the operations of the entire system, including the UPS modules 26, the battery modules 32, and the cooling modules 38. The power block 40 further includes a user interface 44, which in one embodiment can be an HMI (Human Machine Interface) interface, to control and manage the modules 26, 32, 38 contained within the ISO container 12. As shown, the user interface 44 is provided on the near side wall 16 of the ISO container 12 and easily accessible by an operator of the UPS system 10.

Referring to FIG. 4, the UPS system 10 includes a power input 46, which in one embodiment, is provided as part of the power block 40 located on the near side wall 16 of the ISO container 12. The power input 46 is connected to each UPS module 26 to provide mains power to the UPS modules. The UPS system 10 further includes a power output 48, which in the shown embodiment is provided on the far side wall 18 of the ISO container 12. The power output 48 is connected to each battery module 32 and to each UPS module 26 to provide output power to a load connected to the UPS system 10. For example, in the event of failure of mains power, the UPS module 26 and/or the battery module 32 is activated to provide seamless backup power to the load.

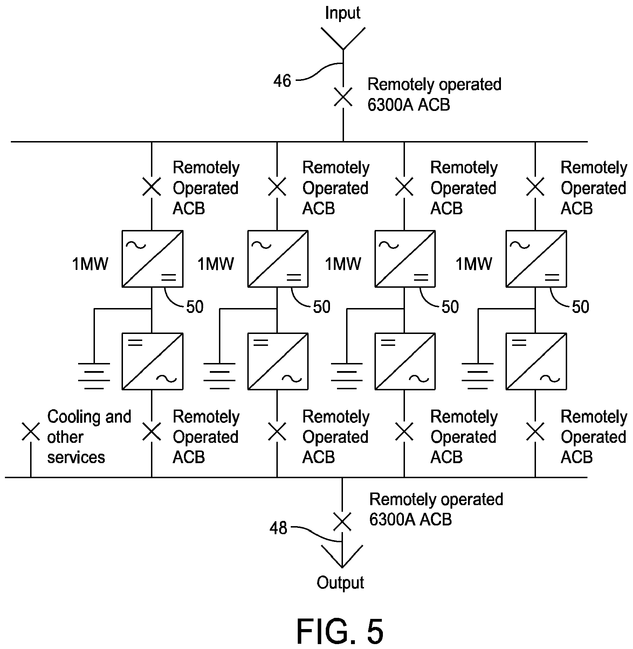

Referring to FIG. 5, the power block 40 of the UPS system 10 includes several circuit breakers, each indicated at 50, coupled to the power input 46 and to the power output 48. In the shown example, there are four (4) circuit breakers, one for each UPS module 26, to cut off power to respective UPS modules. For example, when replacing or maintaining a UPS module 26, the circuit breaker 50 for that particular UPS module can be moved to an off position independently from the other UPS modules. The provision of the circuit breakers 50 enables the easy installation and removal of the UPS modules 26 or maintenance of the UPS modules. In one embodiment, the circuit breakers 50 can be operated via the user interface 44 associated with the power block 40. In another embodiment, in addition to the user interface 44, the circuit breakers 50 can be operated remotely by an operator via a wireless control.

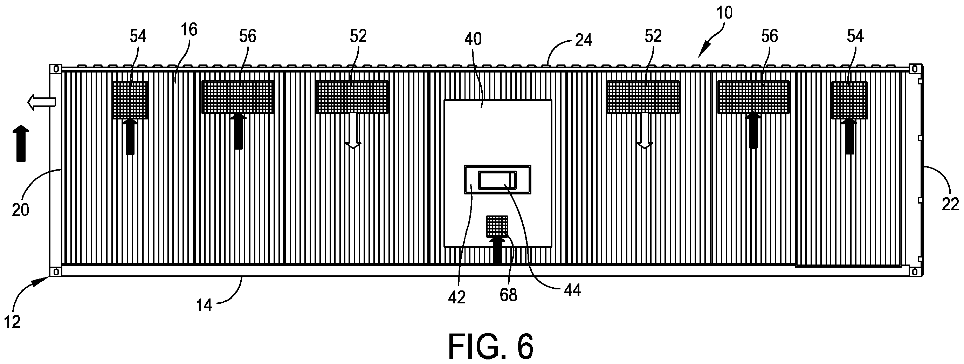

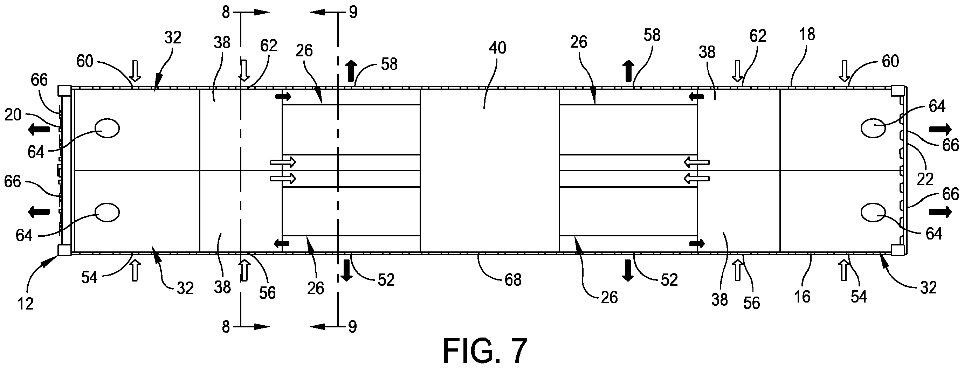

Referring to FIGS. 6 and 7, environmental control, including temperature and humidity control, of the UPS system 10 will be described. As shown, the near side wall 16 of the ISO container 12 includes two exhaust vents, each indicated at 52, adjacent to the UPS modules 26, two inlet vents, each indicated at 54, adjacent to the battery modules 32, and two inlet vents, each indicated at 56, adjacent to the cooling modules 38. Similarly, as best shown in FIG. 7, the far side wall 18 of the ISO container 12 includes two exhaust vents, each indicated at 58, adjacent to the UPS modules 26, two inlet vents, each indicated at 60, adjacent to the battery modules 32, and two inlet vents, each indicated at 62, adjacent to the cooling modules 38. The exhaust vents 58 associated with the UPS modules 26 are configured to exhaust air from the ISO container 12, whereas the inlet vents 60, 62 associated with the battery modules 32 and the cooling modules 38, respectively, are configured to direct air into the ISO container.

As best shown in FIG. 7, each cooling module 38 is configured to direct cool air to its respective, adjacent UPS module 26 to cool the UPS module, with warmed air being exhausted from the ISO module 12 from the exhaust vents 52, 58 associated with the UPS modules. In one embodiment, the first sensor 30 associated with each UPS module 26 is configured to measure temperature within the first housing 28 and the first data relates to temperature data of the first housing. If a temperature of the UPS module 26 is below a preset temperature, then the cooling module 38 is configured to enter into a free cooling mode of operation in which the inlet vent 56 or 62 associated with the cooling module is configured to draw relatively cool air into the ISO module 12 and to direct the air over the UPS module 26. The warmed air from the UPS module 26 is exhausted from the ISO container 12 through the exhaust vent 52 or 58. If a temperature of the UPS module 26 is above the preset temperature, then the cooling module 38 is operated to produce cool air and to direct the cool air over the UPS module.

The UPS system 10 includes a dedicated cooling module, each indicated at 64, provided for each battery module 32. Each dedicated cooling module 64 is configured to direct cool air to its respective battery module 32 to cool the battery module, with warmed air being exhausted from the ISO module 12 from exhaust vents 66 provided in the end walls 20, 22 of the ISO container. Specifically, outside air is drawn into the inlet vents 54, 60 associated with the battery modules 32 provided in the near and far side walls 16, 18 of the ISO container 12. Warm air is exhausted from the battery module 32 through the exhaust vents 66 formed in the end walls 20, 22 of the ISO container 12. In one embodiment, the second sensor 36 associated with each battery module 32 is configured to measure temperature within the second housing 34 and the second data relates to temperature data of the second housing. If a temperature of the battery module 32 is below a preset temperature, then the dedicated cooling module 64 is configured to enter into a free cooling mode in which the inlet vent 54 or 60 associated with the battery module is configured to draw relatively cool air into the ISO module 12 and to direct the air over the battery module. The warmed air from the battery module 32 is exhausted from the ISO container 12 through the exhaust vent 66. If a temperature of the battery module 32 is above the preset temperature, then the dedicated cooling module 64 is operated to direct cool air over the battery module.

The power block 40 includes an inlet vent 68 (FIG. 3) on the near side wall 16 to enable outside air to enter the power block to cool the components housed by the power block. Optionally, although not shown in FIG. 7, the power block 40 can include an outlet vent in the far side wall 18 of the ISO container 12 to exhaust warm air from the power block.

The environmental control of the UPS system 10 can be configured in any number of ways depending on the size and number of UPS modules 26, battery modules 32 and cooling modules 38 provided in the ISO container 12. The cooling configuration is exemplary and designed to optimize the cooling of the particular UPS module 26, battery module 32 and cooling module 38 configuration described herein.

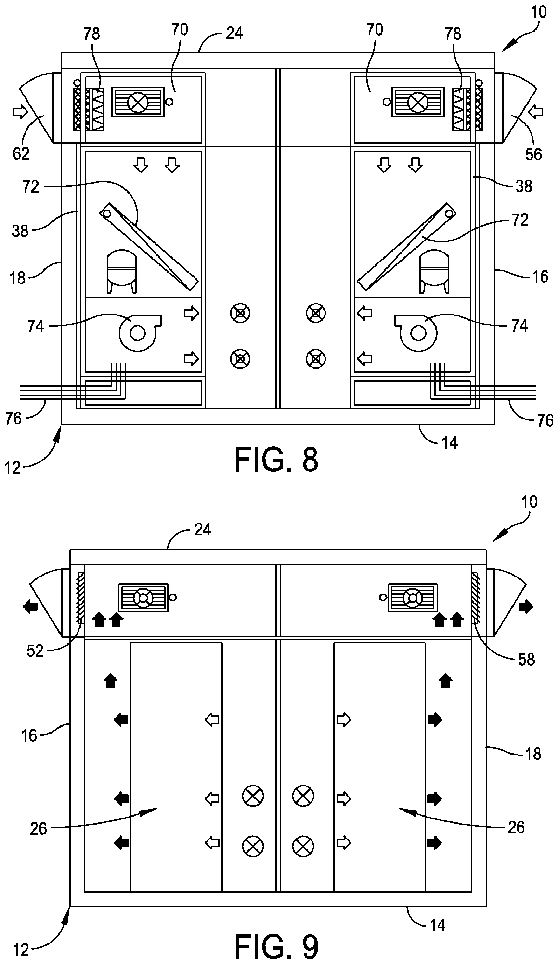

Referring to FIG. 8, which is a cross-sectional view of the UPS system 10 through cooling modules 38 contained within the ISO container 12, the airflow through the cooling modules is illustrated. As shown, for each cooling module 38, outside air is drawn through the inlet vent 56 or 62 through a plenum 70 provided above the cooling module. The outside air is drawn through the cooling module 38 and delivered to the UPS module 26. Each cooling module 38 includes a heat exchanger 72 and a fan 74 used to direct air from the inlet vent 56 or 62 through the cooling module and over the heat exchanger. This cool air is directed to the UPS module 26 that is positioned adjacent to the cooling module 38. Suitable piping 76 is provided to deliver and exhaust coolant to and from the heat exchanger 72. In the free cooling mode of operation, a damper 78 is operated to prevent the air from flowing through the cooling module 38, with the air from the inlet vent 56 or 62 being directed to the UPS module 26 through the plenum 70 provided above the cooling module.

Referring to FIG. 9, which is a cross-sectional view of the UPS system 10 through UPS modules 26 contained within the ISO container 12, the airflow through the UPS modules is illustrated. As shown, for each UPS module 26, cool air provided from its respective cooling module 38 flows through the UPS module to cool heat-generating components with the UPS module. The warmed air from the UPS module 26 flows through the exhaust vents 52, 58 provided in the near and far side walls 16, 18, respectively, of the ISO container 12, as well as the exhaust vents 66 provided in the end walls 20, 22 of the ISO container.

It should be understood that the UPS system 10 described herein is modular in construction and scalable to accommodate a desired load. The UPS system 10 includes low voltage distribution for up to four (4) independent UPS modules 26 and up to four (4) battery modules 32 to provide a minimum of five minutes of battery back-up. The UPS system 10 further includes four (4) cooling modules 38 to provide centralized or free cooling to the UPS modules 26.

In some embodiments, the UPS system 10 provides a low-cost system that is easy to transport and install onsite without specific requirements to comply to local codes.

In some embodiments, the UPS system 10 includes an ISO container 12 that can be reused or repurposed for other uses. The UPS system 10 is easy to maintain and repair since the ISO container 12 is placed outside of the data center facility.

In some embodiments, the UPS system 12 is configured to provide a centralized control system that can manage the UPS modules 26, the battery modules 32 and the cooling modules 38 independently.

In some embodiments, a method of assembling a UPS system includes providing an ISO container described above. One (1) to four(4) UPS modules, battery modules and cooling modules are positioned within the ISO container. In one embodiment, each respective UPS module and battery module is positioned in a row with the respective cooling module being positioned between the UPS module and the battery module. When employing four (4) UPS modules, four (4) battery modules and four (4) cooling modules, the rows of modules are provided at the corners of the ISO container.

The method further may include positioning a power block within the ISO container on the near side wall of the ISO container. The power block includes a central controller that is coupled to the UPS modules, the battery modules and the cooling modules to provide centralized control of these modules. The power block further includes a user interface to control and manage the modules contained within the ISO container.

A method of cooling a UPS system is further disclosed herein. The method includes providing in-row cooling modules adjacent to the UPS modules to provide direct cooling of the UPS modules. The method further includes providing dedicated cooling modules adjacent the battery modules to provide direct cooling of the battery modules. The method further include providing a free cooling mode in which outside air is used to cool the UPS modules and the battery modules of the UPS system.

As mentioned above, various aspects and functions in accordance with the present embodiments may be implemented as specialized hardware or software executing in one or more computer systems associated with the central controller 42 of the UPS system 10. The computer system may include processor, memory, bus, interface, and storage. The processor may perform a series of instructions that result in manipulated data. The processor may be a commercially available processor, multi-processor, microprocessor, or controller as many other processors and controllers are available. The processor may be connected to other system elements, including one or more memory devices, by bus.

Memory may be used for storing programs and data during operation of computer system. Thus, memory may be a relatively high performance, volatile, random access memory such as a dynamic random access memory (DRAM) or static memory (SRAM). However, memory may include any device for storing data, such as a disk drive or other nonvolatile, non-transitory, storage device. Various embodiments in accordance with the present disclosure may organize memory into particularized and, in some cases, unique structures to perform the aspects and functions disclosed herein.

Components of the computer system may be coupled by an interconnection element, such as a bus, which may include one or more physical busses, for example, busses between components that are integrated within a same machine, but may include any communication coupling between system elements including specialized or standard computing bus technologies such as IDE (Integrated Drive Electronics), SCSI (Small Computer System Interface), PCI (Peripheral Component Interconnect), and InfiniBand. Thus, the bus enables communications, for example, data and instructions, to be exchanged between system components of computer system.

The computer system also may include one or more interface devices, such as input devices, output devices, and combination input/output devices. Interface devices may receive input or provide output. More particularly, output devices may render information for external presentation. The interface devices may include, for example, one or more graphical user interfaces that may be disposed proximate to or separate from other components of the computer system. A graphical user interface of the computer system may, for example, be displayed through a web browser that accesses information from the memory. Input devices may accept information from external sources. Examples of interface devices include keyboards, mouse devices, trackballs, microphones, touch screens, printing devices, display screens, speakers, network interface cards, etc. The interface devices allow computer system to exchange information and communicate with external entities, such as users and other systems.

The storage system may include a computer readable and writeable, nonvolatile, non-transitory, storage medium in which instructions are stored that define a program to be executed by the processor. The program to be executed by the processor may cause the processor or computer system to perform any one or more embodiments of the methods disclosed herein. The storage system also may include information that is recorded, on or in, the medium, and this information may be processed by the program. More specifically, the information may be stored in one or more data structures specifically configured to conserve storage space or increase data exchange performance. The instructions may be persistently stored as encoded signals, and the instructions may cause a processor to perform any of the functions described herein. The medium may, for example, be optical disk, magnetic disk, or flash memory, among others. In operation, the processor or some other controller may cause data to be read from the nonvolatile recording medium into another memory, such as memory, that allows for faster access to the information by the processor than does the storage medium included in storage system. The memory may be located in storage system or in memory, however, processor may manipulate the data within the memory, and then may copy the data to the medium associated with storage system after processing is completed. A variety of components may manage data movement between the medium and integrated circuit memory element and the presently described embodiments are not limited thereto. Further, the embodiments are not limited to a particular memory system or data storage system. Portions of the memory or storage system may be included in the same computer system as other components of the computer system or may be resident in a cloud-based system that is accessible via the internet or other communications system or protocol.

Although the computer system is shown by way of example as one type of computer system upon which various aspects and functions in accordance with the present embodiments may be practiced, any aspects of the presently disclosed embodiments are not limited to being implemented on the computer system. Various aspects and functions in accord with the presently disclosed embodiments may be practiced on one or more computers having a different architectures or components. For instance, computer system may include specially-programmed, special-purpose hardware, such as for example, an application-specific integrated circuit (ASIC) tailored to perform a particular operation disclosed herein. While another embodiment may perform the same function using several general-purpose computing devices running MAC OS System X with Motorola PowerPC processors and several specialized computing devices running proprietary hardware and operating systems.

The computer system may be a computer system including an operating system that manages at least a portion of the hardware elements included in computer system. Usually, a processor or controller, such as processor, executes a commercially available operating system. Many types of operating systems may be used, and embodiments are not limited to any particular implementation.

The processor and operating system together define a computer platform for which application programs in high-level programming languages may be written. These component applications may be executable, intermediate, for example, C-, bytecode or interpreted code which communicates over a communication network, for example, the Internet, using a communication protocol, for example, TCP/IP (Transmission Control Protocol/Internet Protocol). Similarly, aspects in accord with the presently disclosed embodiments may be implemented using an object-oriented programming language, such as .Net, SmallTalk, Java, C++, Ada, or C# (C-Sharp). Other object-oriented programming languages may also be used. Alternatively, functional, scripting, or logical programming languages may be used.

Additionally, various aspects and functions in accordance with the presently disclosed embodiments may be implemented in a non-programmed environment, for example, documents created in HTML, XML, or other format that, when viewed in a window of a browser program, render aspects of a graphical-user interface or perform other functions. Further, various embodiments in accord with the present disclosure may be implemented as programmed or non-programmed elements, or any combination thereof. For example, a web page may be implemented using HTML while a data object called from within the web page may be written in C++. Thus, the presently disclosed embodiments are not limited to a specific programming language and any suitable programming language could also be used.

A computer system included within an embodiment may perform additional functions outside the scope of the presently disclosed embodiments. For instance, aspects of the system may be implemented using an existing commercial product, such as, for example, Database Management Systems such as SQL Server available from Microsoft of Seattle WA., Oracle Database from Oracle of Redwood Shores, CA, and MySQL from MySQL AB, a subsidiary of Oracle or integration software such as Web Sphere middleware from IBM of Armonk, NY. However, a computer system running, for example, SQL Server may be able to support both aspects in accord with the presently disclosed embodiments and databases for sundry applications.

It is to be appreciated that examples of the methods, systems, and apparatuses discussed herein are not limited in application to the details of construction and the arrangement of components set forth in the following description or illustrated in the accompanying drawings. The methods, systems, and apparatuses are capable of implementation in other examples and of being practiced or of being carried out in various ways. Examples of specific implementations are provided herein for illustrative purposes only and are not intended to be limiting. Examples disclosed herein may be combined with other examples in any manner consistent with at least one of the principles disclosed herein, and references to "an example," "some examples," "an alternate example," "various examples," "one example" or the like are not necessarily mutually exclusive and are intended to indicate that a particular feature, structure, or characteristic described may be included in at least one example. The appearances of such terms herein are not necessarily all referring to the same example. Also, the phraseology and terminology used herein is for the purpose of description and should not be regarded as limiting. The use herein of "including," "comprising," "having," "containing," "involving," and variations thereof is meant to encompass the items listed thereafter and equivalents thereof as well as additional items. References to "or" may be construed as inclusive so that any terms described using "or" may indicate any of a single, more than one, and all of the described terms. Any references to front and back, left and right, top and bottom, upper and lower, and vertical and horizontal are intended for convenience of description, not to limit the present systems and methods or their components to any one positional or spatial orientation.

Having thus described several aspects of at least one embodiment of this disclosure, it is to be appreciated various alterations, modifications, and improvements will readily occur to those skilled in the art. Such alterations, modifications, and improvements are intended to be part of this disclosure, and are intended to be within the scope of the disclosure. Accordingly, the foregoing description and drawings are by way of example only.

## Claims

1. A UPS system (10) comprising:
a UPS module (26) including a first housing (28) and a first sensor (30) outputting first data;
a battery module (32) including a second housing (34) and a second sensor (36) outputting second data; and
a central controller (42) that is external to the first housing of the UPS module and the second housing of the battery module,
wherein the central controller is coupled to the UPS module and the battery module and is configured to receive the first data and the second data.

2. The UPS system of claim 1, further comprising a cooling module (38) including a third housing and being configured to provide cooling to the UPS module.

3. The UPS system of claims 1 or 2, wherein the first sensor is configured to measure temperature within the first housing and the first data relates to temperature data of the first housing.

4. The UPS system of any of claims 1-3, wherein the central controller is configured to control the operation of the cooling module based on the first data and the second data.

5. The UPS system of any of claims 1-4, wherein the cooling module includes a heat exchanger (72) and a fan (74) configured to move air over the heat exchanger.

6. The UPS system of claim 1, wherein the second sensor is configured to measure a state of charge of the battery module and the second data relates to the state of charge.

7. The UPS system of claims 1 or 6, wherein the second sensor is configured to measure temperature within the second housing and the second data relates to temperature data of the second housing.

8. The UPS system of any preceding claim, wherein the battery module includes a dedicated cooling module coupled to the central controller and configured to direct cool air to the battery module.

9. The UPS system of any preceding claim, further comprising a power block (40) including the central controller.

10. The UPS system of any preceding claim, further comprising a user interface (44) coupled to the central controller, the user interface being configured to enable a user to control the operation of at least one of the UPS module or the battery module.

11. The UPS system of any preceding claim, further comprising at least one additional UPS module coupled to the central controller.

12. The UPS system of any preceding claim, further comprising at least one additional battery module coupled to the central controller.

13. The UPS system of any preceding claim, further comprising a frame structure configured to contain at least one of the UPS module, the battery module and the power block, the central controller being coupled to the frame structure.

14. The UPS system of claim 13, wherein the frame structure includes a first vent configured to direct cool air to flow over at least one of the battery module and the power block and a second vent configured to exhaust warm air from the at least one of the battery module and the power block.

15. The UPS system of claims 13 or 14, wherein the frame structure is an ISO container (12).
